# FASCICULE DE BREVET EUROPEEN

(11) **EP 3 895 217 B1**
(45) Date de publication et mention de la délivrance du brevet: **26.07.2023**
(21) Numéro de dépôt: 19816748.8
(22) Date de dépôt: 12.12.2019
(51) Int. Cl.: H10B 63/00

(54) **MEMOIRE RESISTIVE EN TROIS DIMENSIONS ET PROCEDE PERMETTANT D'OBTENIR UNE TELLE MEMOIRE**
DREIDIMENSIONALER RESISTIVER SPEICHER UND VERFAHREN ZUR HERSTELLUNG SOLCH EINES SPEICHERS
THREE-DIMENSIONAL RESISTIVE MEMORY AND METHOD ALLOWING SUCH A MEMORY TO BE OBTAINED

(30) Priorité: 13.12.2018 FR 1872842
(43) Date de publication de la demande: 20.10.2021
(73) Titulaire: Commissariat à l'Energie Atomique et aux Energies Alternatives, 75015 Paris (FR)
(72) Inventeur: EL HAJJAM, Khalil, 38054 GRENOBLE CEDEX 09 (FR)
(74) Mandataire: Cabinet Camus Lebkiri
(86) Numéro de dépôt international: PCT/EP2019/084813
(87) Numéro de publication internationale: WO 2020/120654

(56) Documents cités:
- FR-A1- 3 066 043
- US-A1- 2003 185 048
- US-A1- 2013 134 382
- US-A1- 2017 141 161

## Description

### DOMAINE TECHNIQUE DE L'INVENTION

Le domaine technique de l'invention est celui des mémoires. La présente invention concerne une mémoire en trois dimensions (ci-après 3D) et en particulier une mémoire en 3D dans laquelle un sélecteur est associé à chaque point mémoire pour former une cellule mémoire. L'invention concerne également un procédé permettant d'obtenir une telle mémoire.

### ARRIERE-PLAN TECHNOLOGIQUE DE L'INVENTION

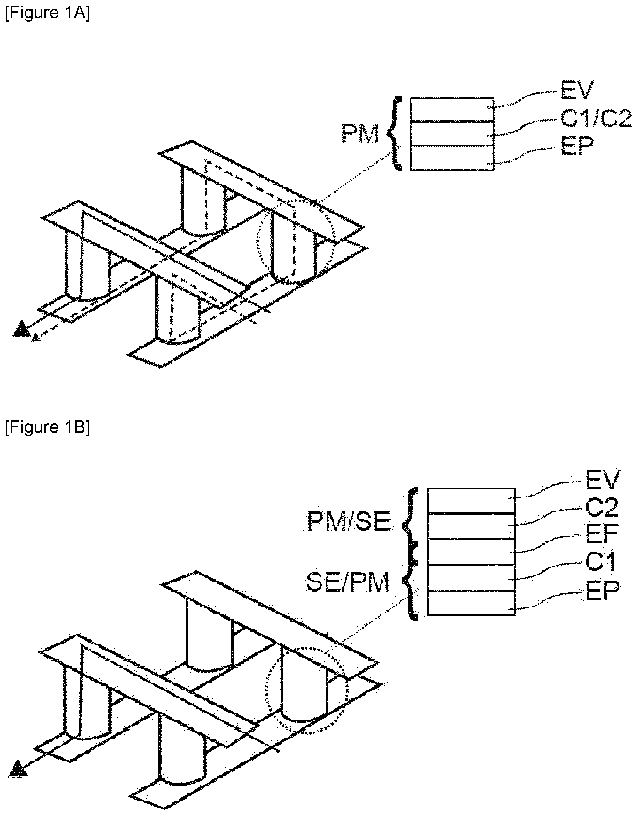

Selon l'invention Dans la technologie des mémoires en deux dimensions (ci-après 2D), un problème connu lié à l'adressage d'un point mémoire PM est celui des chemins de fuite. En effet, comme illustré à la figure 1A, lorsque l'on applique un potentiel de lecture sur une ligne et sur une colonne afin de lire un point mémoire PM d'une matrice de points mémoire PM, le courant passe non seulement par le point mémoire PM cible (c'est-à-dire situé à l'intersection de la ligne et de la colonne sélectionnées - flèche en ligne continue), mais également par des chemins parasites (au travers des points mémoires PM non adressés en basse résistance - flèches en ligne pointillée) qui peuvent altérer la lecture du point mémoire PM.

Dans les structures 2D, il est aisé de réduire voire supprimer le problème de chemins parasites en insérant un sélecteur SE entre le point mémoire PM et la colonne ou la ligne d'adressage comme cela est illustré figure 1B. Un sélecteur SE est composé d'une électrode flottante EF (c'est-à-dire qu'elle n'est reliée à aucune référence de potentiel lors du fonctionnement de la mémoire) d'un matériau actif C1/C2, en général choisi en fonction du matériau actif C2/C1 utilisé pour le point mémoire PM et d'une électrode EP/EV. Cependant, une telle configuration n'a jusqu'à présent pas été mise en place dans le cas des mémoires en 3D. En effet, dans le cas d'une mémoire en 3D, la mise en place d'un sélecteur SE entrainerait un court-circuit entre les électrodes planes EP, ledit court-circuit étant provoqué par l'électrode flottante EF. Le document FR 3 066 043 divulgue une électrode verticale et deux électrodes planes, avec deux couches d'un matériau actif.

Il existe donc un besoin d'une mémoire en 3D comprenant des sélecteurs SE afin de diminuer ou supprimer le problème de chemins de fuite. Il existe également un besoin d'un procédé permettant d'obtenir une telle mémoire.

### RESUME DE L'INVENTION

L'invention offre une solution aux problèmes évoqués précédemment, en proposant un dispositif mémoire en 3D comprenant un sélecteur pour chaque point mémoire. Pour mémoire, une mémoire 3D est le résultat d'une stratégie d'intégration où les dispositifs sont organisés dans les trois directions de l'espace, et plus uniquement sur un plan horizontal comme dans les mémoires traditionnelles 2D. Cette configuration permet d'améliorer les performances des dispositifs mémoire tout en augmentant la densité de stockage (et donc de réduire les coûts de fabrication).

Un aspect de l'invention concerne une mémoire, en particulier une mémoire en 3D, comprenant au moins une cellule mémoire, de préférence une pluralité de cellule mémoires, chaque cellule mémoire comprenant :
- une première électrode, dite électrode plane, s'étendant essentiellement selon un premier plan ;
- une deuxième électrode, dite électrode flottante, s'étendant essentiellement selon un deuxième plan, parallèle au premier plan ;
- une troisième électrode, dite électrode verticale, s'étendant essentiellement selon une direction perpendiculairement au premier plan.

De plus, l'électrode plane comporte au moins une première partie en regard d'une première partie de l'électrode flottante, la première partie de l'électrode plane et la première partie de l'électrode flottante étant séparées par une première couche d'un premier matériau actif. De même, l'électrode verticale comporte au moins une première partie en regard d'une deuxième partie de l'électrode flottante, la première partie de l'électrode verticale et la deuxième partie de l'électrode flottante étant séparées par une deuxième couche d'un deuxième matériau actif. Enfin, le premier matériau actif est apte à former un sélecteur ou un point mémoire et le deuxième matériau actif est apte à former un point mémoire ou un sélecteur. De plus, la première électrode et la deuxième électrode ne partagent aucun plan qui soit parallèle au premier plan ou au deuxième plan.

Grâce à l'invention, chaque point mémoire est associé à un sélecteur ce qui permet de réduire voire d'éliminer les problèmes de chemins de fuite lors de l'adressage d'un point mémoire. De plus, chaque point mémoire est associé à un sélecteur dont la géométrie peut être contrôlée.

Outre les caractéristiques qui viennent d'être évoquées dans le paragraphe précédent, la mémoire selon un premier aspect de l'invention peut présenter une ou plusieurs caractéristiques complémentaires parmi les suivantes, considérées individuellement ou selon toutes les combinaisons techniquement possibles.

Avantageusement, la première couche d'un premier matériau isolant est séparée de la deuxième couche d'un deuxième matériau actif par une deuxième distance de séparation TR2, la deuxième distance TR2 étant choisie en fonction de la nature du premier matériau actif.

Un deuxième aspect de l'invention concerne un procédé de fabrication d'une mémoire comprenant au moins une cellule mémoire, ledit procédé comprenant :
- une première étape de dépôt d'une première couche d'un premier matériau isolant ;
- une deuxième étape de dépôt d'une première couche d'un matériau conducteur ;
- une troisième étape de dépôt d'une deuxième couche d'un deuxième matériau isolant ;
lesdites première étape de dépôt d'une première couche d'un premier matériau isolant, deuxième étape de dépôt d'une première couche d'un matériau conducteur et une troisième étape de dépôt d'une deuxième couche d'un deuxième matériau isolant pouvant être itérées une pluralité de fois.

De plus, le procédé selon un deuxième aspect de l'invention comprend également :
- une première étape de gravure anisotropique, de sorte à créer une ouverture dans la première couche d'un premier matériau isolant, la première couche d'un matériau conducteur et la deuxième couche d'un deuxième matériau isolant ;
- une première étape de gravure sélective de la première couche d'un matériau conducteur de sorte à former un retrait dans ladite première couche d'un matériau conducteur ;
- une étape de dépôt ou de croissance d'une troisième couche d'un troisième matériau isolant de sorte à combler le retrait obtenu lors de la première étape de gravure sélective de la première couche d'un matériau conducteur ;
- une deuxième étape de gravure sélective de la première couche d'un premier matériau isolant ;
- une première étape de dépôt conforme d'une première couche d'un premier matériau actif ;
- une cinquième étape de dépôt d'une deuxième couche d'un matériau conducteur ;
- une troisième étape de gravure anisotrope de la première couche d'un premier matériau actif et de la deuxième couche d'un matériau conducteur ;
- une deuxième étape de dépôt conforme d'une deuxième couche d'un deuxième matériau actif ;
- une sixième étape de dépôt d'une troisième couche d'un matériau conducteur ;
le premier matériau actif étant apte à former un sélecteur ou un point mémoire et le deuxième matériau actif étant apte à former un point mémoire ou un sélecteur.

Un troisième aspect de l'invention concerne un procédé de fabrication d'une mémoire comprenant au moins une cellule mémoire, ledit procédé comprenant :
- une première étape de dépôt d'une première couche d'un premier matériau isolant ;
- une septième étape de dépôt d'une première couche d'un premier matériau actif ;
- une deuxième étape de dépôt d'une première couche d'un matériau conducteur ;
- une troisième étape de dépôt d'une deuxième couche d'un deuxième matériau isolant ;
lesdites première étape de dépôt d'une première couche d'un premier matériau isolant, septième étape de dépôt d'une première couche d'un premier matériau actif, deuxième étape de dépôt d'une première couche d'un matériau conducteur et troisième étape de dépôt d'une deuxième couche d'un deuxième matériau isolant pouvant être itérées une pluralité de fois.

De plus, le procédé selon un troisième aspect de l'invention comprend également :
- une première étape de gravure anisotropique, de sorte à créer une ouverture dans la première couche d'un premier matériau isolant, la première couche d'un premier matériau actif, la première couche d'un matériau conducteur et la deuxième couche d'un deuxième matériau isolant ;
- une première étape de gravure sélective de la première couche d'un matériau conducteur de sorte à former un retrait dans ladite première couche d'un matériau conducteur ;
- une étape de dépôt ou de croissance d'une troisième couche d'un troisième matériau isolant de sorte à combler le retrait obtenu lors de la première étape de gravure sélective de la première couche d'un matériau conducteur ;
- une deuxième étape de gravure sélective de la première couche d'un premier matériau isolant ;
- une cinquième étape de dépôt d'une deuxième couche d'un matériau conducteur ;
- une troisième étape de gravure anisotrope de la deuxième couche d'un matériau conducteur ;
- une deuxième étape de dépôt conforme d'une deuxième couche d'un deuxième matériau actif ;
- une sixième étape de dépôt d'une troisième couche d'un matériau conducteur ;
le premier matériau actif étant apte à former un sélecteur ou un point mémoire et le deuxième matériau actif étant apte à former un point mémoire ou un sélecteur.

Le procédé selon un deuxième ou un troisième aspect de l'invention permet d'exercer un contrôle précis sur la géométrie du sélecteur et/ou du point mémoire dans une structure en 3D à travers notamment les dimensions des retraits obtenus lors des deux étapes de gravure sélective.

Outre les caractéristiques qui viennent d'être évoquées dans le paragraphe précédent, le procédé selon un deuxième ou un troisième aspect de l'invention peut présenter une ou plusieurs caractéristiques complémentaires parmi les suivantes, considérées individuellement ou selon toutes les combinaisons techniquement possibles.

Avantageusement, lorsque l'étape de dépôt ou de croissance d'une troisième couche d'un troisième matériau isolant est une étape de dépôt, alors ladite étape comprend :
- une première sous-étape étape de dépôt d'une troisième couche d'un troisième matériau isolant ;
- une deuxième sous-étape de gravure anisotrope de la troisième couche d'un troisième matériau isolant.

Avantageusement, l'étape de dépôt ou de croissance d'une troisième couche d'un troisième matériau isolant est une étape de croissance thermique.

Avantageusement, le matériau conducteur est choisi parmi le TiN, TaN, TaCN, Ta, Ti, W, Cu, Ru, Mo, Co, C, Al et/ou Ag, ou un alliage comprenant au moins deux desdits métaux.

Avantageusement, lorsque le matériau actif est destiné à former un sélecteur, alors ce dernier est choisi parmi le VOx, GeSe, TiOx, TaxOy.

Avantageusement, lorsque le matériau actif est destiné à former un point mémoire, alors ce dernier est choisi parmi le HfOx, AlxOy, TaxOy, CuTeGe, GST, TiOx, SiOx.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique d'un dispositif mémoire 2D sans (figure 1A) et avec (figure 1B) sélecteur.
- La figure 2 montre une représentation schématique d'une mémoire selon un mode de réalisation d'un premier aspect de l'invention.
- La figure 3 montre une représentation schématique d'une mémoire selon un mode de réalisation d'un premier aspect de l'invention.
- La figure 4 montre une représentation schématique des étapes d'un procédé selon un mode de réalisation d'un deuxième aspect de l'invention.
- La figure 5 montre une représentation schématique d'une cellule mémoire obtenue à l'aide d'un procédé selon un deuxième aspect de l'invention.
- La figure 6 montre un logigramme d'un procédé selon un deuxième aspect de l'invention.
- La figure 7 montre une représentation schématique d'un empilement obtenu au cours de la mise en oeuvre d'un procédé selon un troisième aspect de l'invention.
- La figure 8 montre une représentation schématique d'une cellule mémoire d'une mémoire obtenue à l'aide d'un procédé selon un troisième aspect de l'invention.
- La figure 9 montre un logigramme d'un procédé selon un troisième aspect de l'invention.

### DESCRIPTION DETAILLEE D'AU MOINS UN MODE DE REALISATION DE L'INVENTION

Sauf précision contraire, un même élément apparaissant sur des figures différentes présente une référence unique.

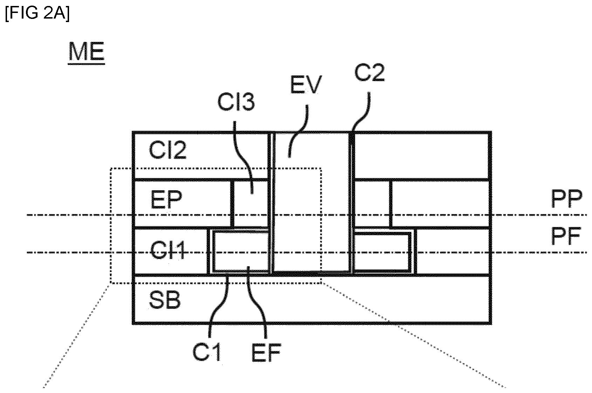

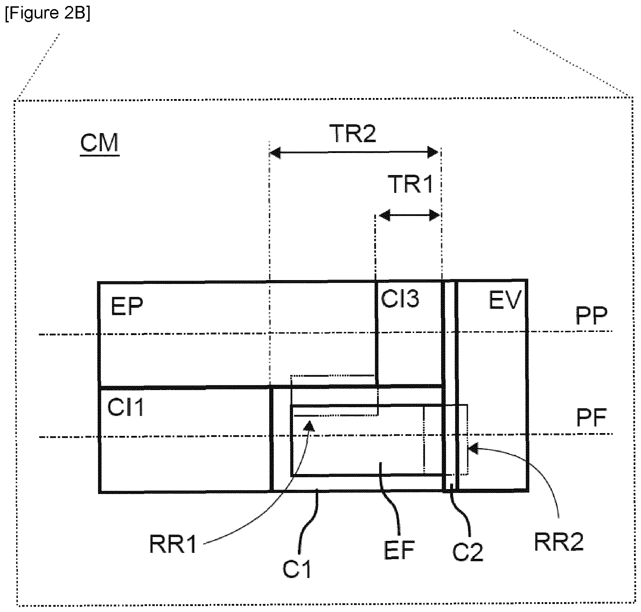

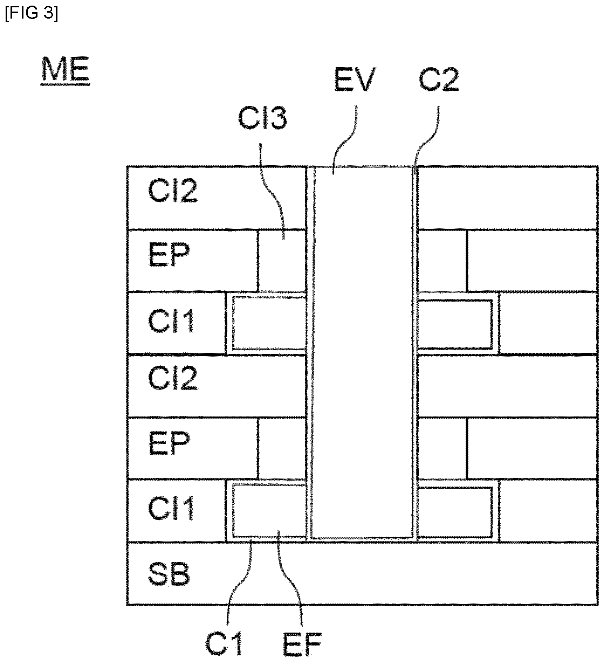

Comme illustré à la figure 2 et à la figure 3, un premier mode de réalisation d'un premier aspect de l'invention concerne une mémoire ME, en particulier une mémoire en trois dimensions, comprenant au moins une cellule mémoire CM, de préférence une pluralité de cellules mémoire CM (comme illustré à la figure 3 où ladite mémoire comporte deux cellules mémoires). Chaque cellule mémoire CM comprend une première électrode, dite électrode plane EP, s'étendant essentiellement selon un premier plan PP, une deuxième électrode, dite électrode flottante EF, s'étendant essentiellement selon un deuxième plan PF, parallèle au premier plan PP et une troisième électrode, dite électrode verticale EV, s'étendant essentiellement selon une direction perpendiculaire au premier plan PP et au deuxième plan PF. De plus, l'électrode plane EP comporte au moins une première partie en regard d'une première partie de l'électrode flottante EF au niveau d'une première région RR1, la première partie de l'électrode plane EP et la première partie de l'électrode flottante EF étant séparées par une première couche C1 d'un premier matériau actif. De même, l'électrode verticale EV comporte au moins une première partie en regard d'une deuxième partie de l'électrode flottante EF au niveau d'une deuxième région RR2, la première partie de l'électrode verticale EV et la deuxième partie de l'électrode flottante EF étant séparée par une deuxième couche C2 d'un deuxième matériau actif. Enfin, la première électrode EP et la deuxième électrode EF ne partagent aucun plan qui soit parallèle au premier plan PP ou au deuxième plan PF. Autrement dit, les deux électrodes se situent dans deux plans différents. L'électrode verticale EV est de préférence de forme cylindrique, encore plus préférentiellement, un cylindre circulaire droit. Pour mémoire, un cylindre est une surface réglée dont les génératrices sont parallèles. La largeur (ou le diamètre pour le cylindre circulaire droit) de l'électrode verticale EV est limitée par la hauteur dudit cylindre et des procédés de fabrication utilisés. En particulier, l'aspect de forme maximum autorisé par un procédé donné permettra de connaitre le diamètre minimum de l'électrode verticale EV en fonction de la hauteur de cette dernière. Les matériaux conducteurs de l'électrode verticale EV, de l'électrode plane EP et de l'électrode flottante EF peuvent être choisis parmi le TiN, TaN, TaCN, Ta, Ti, W, Cu, Ru, Mo, Co, C, Al et/ou Ag ou leurs alliages.

Par ailleurs, le premier matériau actif C1 est apte à former un sélecteur SE ou un point mémoire PM et le deuxième matériau actif C2 est apte à former un point mémoire PM ou un sélecteur SE. Ainsi, chaque cellule mémoire CM comprend un sélecteur SE et un point mémoire PM. Le matériau utilisé pour obtenir un sélecteur peut notamment comprendre du VOx, GeSe, TiOx, TaxOy. Le matériau utilisé pour obtenir un point mémoire peut notamment comprendre HfOx, AlxOy, TaxOy, CuTeGe, GST, TiOx, SiOx. Par exemple, le premier matériau actif (respectivement le deuxième matériau actif) est du GeSe alors que le deuxième matériau actif (respectivement le premier matériau actif) est du GST (GeSbTe).

La mémoire ME ainsi obtenue présente de nombreux avantages. Elle permet notamment de réduire voire supprimer les chemins de fuite grâce à la présence d'un sélecteur SE associé à un point mémoire PM dans chaque cellule mémoire CM. Dans la suite, on entend par point mémoire PM l'ensemble constitué par deux électrodes (par exemple l'électrode plane EP et l'électrode flottante EF ou l'électrode flottante EF et l'électrode verticale EV) entourant un matériau actif (par exemple la première couche C1 d'un premier matériau actif ou la deuxième couche C2 d'un deuxième matériau actif) apte à former un point mémoire PM. De manière similaire, on entend par sélecteur SE l'ensemble constitué par deux électrodes entourant un matériau actif apte à former un sélecteur SE. L'arrangement de chaque cellule mémoire CM permet également de moduler au travers de deux distances la surface d'échange entre l'électrode flottante EF et l'électrode plane EP. Ces deux longueurs sont représentées sur la figure 2B. La première TR1 de ces distances est la distance séparant l'électrode plane EP de la deuxième couche C2 d'un deuxième matériau actif. La deuxième TR2 de ces distances correspondant à la distance séparant la première couche CI1 d'un premier matériau isolant de la deuxième couche C2 d'un deuxième matériau actif.

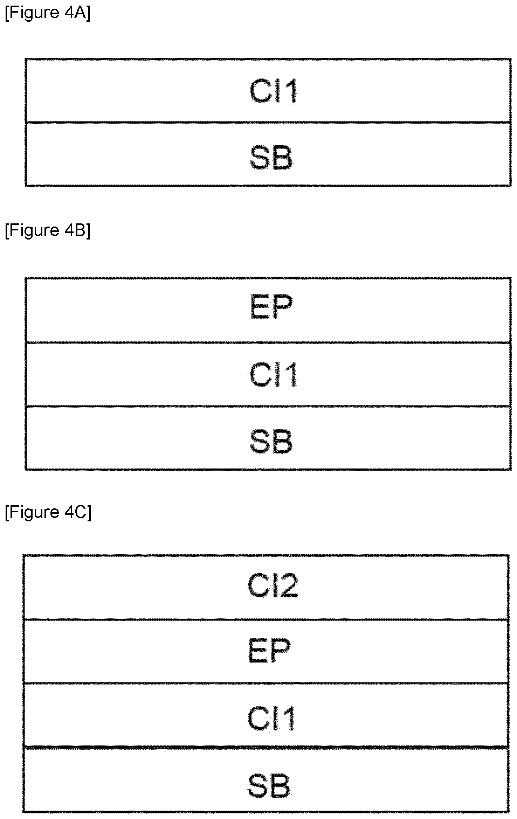

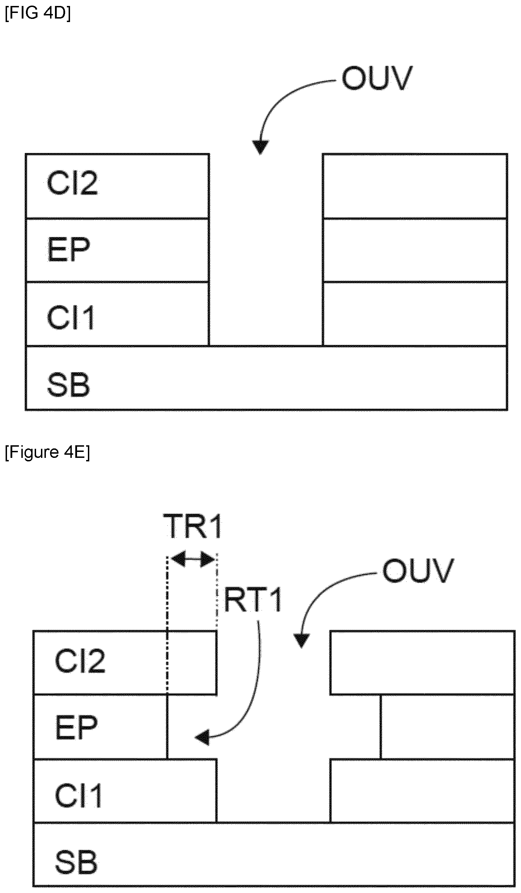

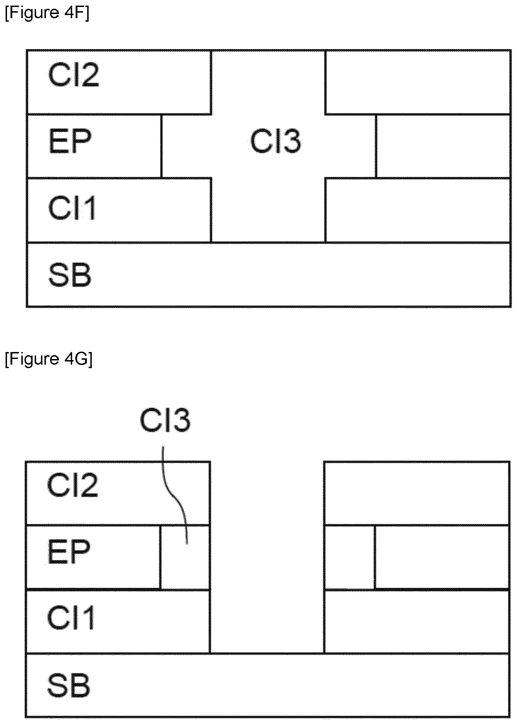

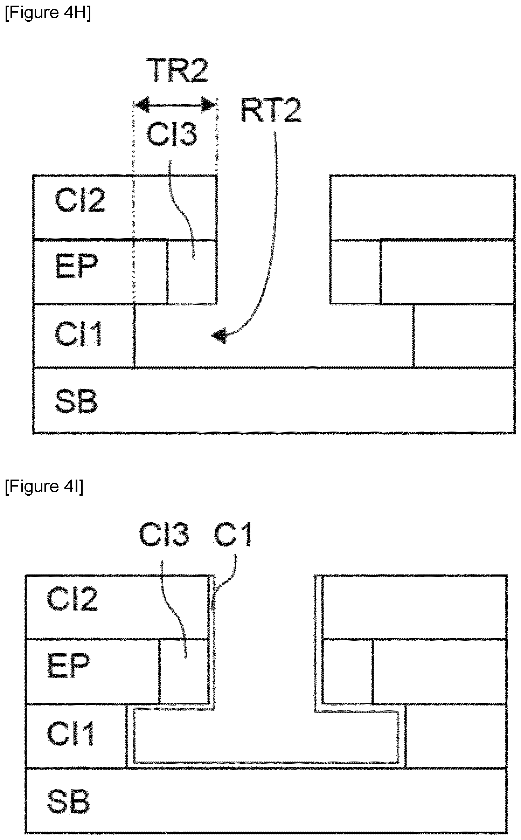

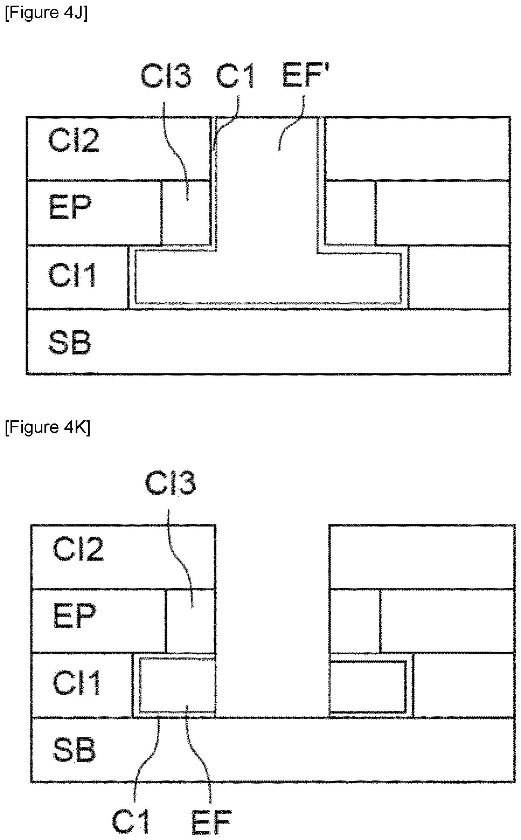

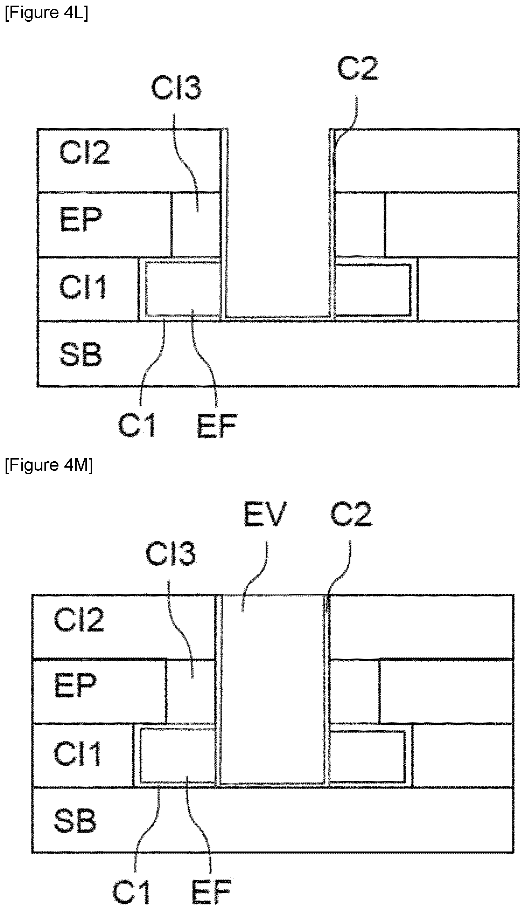

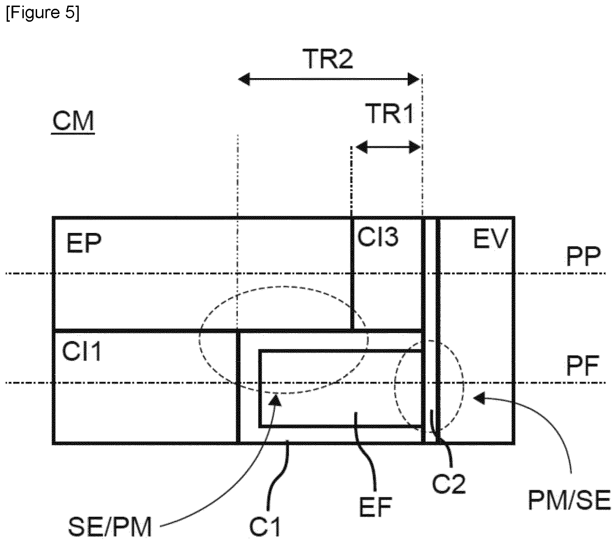

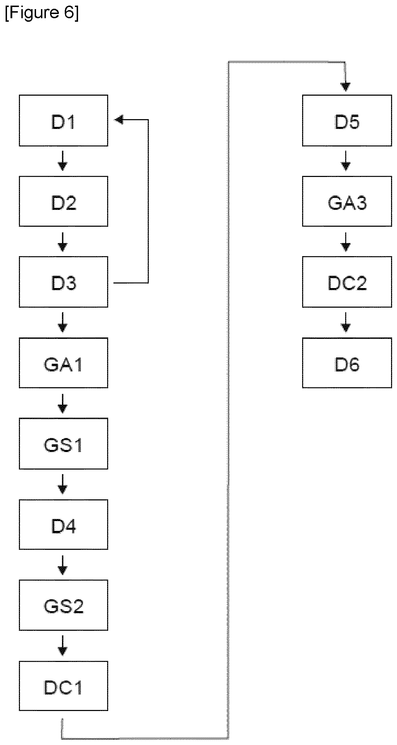

Un deuxième aspect de l'invention concerne un procédé de fabrication permettant d'obtenir une mémoire ME selon un premier aspect de l'invention. Un mode de réalisation d'un deuxième aspect de l'invention illustré à la figure 4, à la figure 5 et à la figure 6 concerne un procédé de fabrication d'une mémoire ME comprenant au moins une cellule mémoire CM, de préférence une pluralité de cellules mémoire CM.

Comme illustré à la figure 4A, le procédé comprend une première étape D1 de dépôt d'une première couche CI1 d'un premier matériau isolant. Dans un mode de réalisation, le premier matériau isolant est du SiN. Dans un mode de réalisation, l'épaisseur de la première couche CI1 d'un premier matériau isolant est comprise entre 15 nm et 25 nm, de préférence égale à 20 nm. De manière plus générale, l'épaisseur de la première couche CI1 d'un premier matériau isolant détermine l'épaisseur de l'électrode flottante EF et doit donc être choisie en fonction des contraintes techniques concernant ladite électrode flottante EF. Le dépôt peut être effectué sur un substrat SB, par exemple un substrat SB de silicium.

Comme illustré à la figure 4B, le procédé comprend ensuite une deuxième étape D2 de dépôt d'une première couche EP d'un matériau conducteur sur la première couche CI1 d'un premier matériau isolant. Dans un mode de réalisation, le matériau conducteur est choisi parmi le TiN, TaN, TaCN, Ta, Ti, W, Cu, Ru, Mo, Co, C, Al et/ou Ag, ou un de leurs alliages. Dans un mode de réalisation, l'épaisseur de la première couche EP d'un matériau conducteur est comprise entre 15 nm et 25 nm, de préférence égale à 20 nm.

Comme illustré à la figure 4C, le procédé comprend ensuite une troisième étape D3 de dépôt d'une deuxième couche CI2 d'un deuxième matériau isolant sur la première couche EP d'un matériau conducteur. Dans un mode de réalisation, le deuxième matériau isolant est du SiOx. Dans un mode de réalisation l'épaisseur de la deuxième couche CI2 d'un deuxième matériau isolant est comprise entre 15 nm et 25 nm, de préférence égale à 20 nm.

Lorsque l'on désire fabriquer une pluralité de cellules mémoires CM comme illustré à la figure 3, ces trois premières étapes D1, D2, D3 sont répétées autant de fois que de nombre de cellules mémoires CM souhaitées par électrode verticale EV. Dans un mode de réalisation, le nombre de répétitions est compris entre deux et soixante-quatre. On notera que la première étape D1 de dépôt d'une première couche CI1 d'un premier matériau isolant et la troisième étape D3 de dépôt d'une deuxième couche CI2 d'un deuxième matériau isolant peuvent être permutées entre chaque répétition. Par exemple, dans le cas de deux répétitions des trois étapes ci-dessus, l'alternance de couche CI1/EP/CI2 peut être suivie d'une alternance de couche CI2/EP/CI1 de sorte à obtenir l'empilement CI1/EP/CI2/CI2/EP/CI1.

Une fois l'empilement obtenu, comme illustré à la figure 4D, le procédé selon l'invention comprend une première étape GA1 de gravure anisotropique, de sorte à créer une ouverture OUV dans la première couche CI1 d'un premier matériau isolant, la première couche EP d'un matériau conducteur et la deuxième couche CI2 d'un deuxième matériau isolant. L'ouverture OUV destinée notamment à former l'électrode verticale EV est de préférence de forme cylindrique, encore plus préférentiellement, un cylindre circulaire droit. Pour mémoire, un cylindre est une surface réglée dont les génératrices sont parallèles. La largeur (ou le diamètre pour le cylindre circulaire droit) de l'ouverture OUV (et donc de l'électrode verticale EV) est limitée par la hauteur dudit cylindre et des procédés de fabrication utilisés. En particulier, l'aspect de forme maximum autorisé par un procédé donné permettra de connaitre le diamètre minimum de l'électrode verticale EV en fonction de la hauteur de cette dernière. Dans un mode de réalisation, le diamètre de l'ouverture OUV est compris entre 40 nm et 100 nm. Lorsqu'une pluralité de cellules mémoires CM est souhaitée la gravure est réalisée de sorte à créer une ouverture OUV dans la pluralité de premières couches CI1 d'un premier matériau isolant, la pluralité de premières couches EP d'un matériau conducteur et la pluralité de deuxièmes couches C12 d'un deuxième matériau isolant. De même, lorsque l'on souhaite une pluralité d'électrodes verticales EV, la première étape GA1 de gravure anisotropique est réalisée de sorte à créer une pluralité d'ouvertures OUV telles que celle précédemment décrite.

Comme illustré à la figure 4E, le procédé comprend ensuite une première étape GS1 de gravure sélective de la première couche EP d'un matériau conducteur. On entend par gravure sélective le fait que, lors de ladite gravure, la vitesse de gravure de la première couche EP d'un premier matériau conducteur est supérieure à la vitesse de gravure des autres couches. Cette gravure va permettre de créer un retrait RT1 dans la surface latérale de l'ouverture OUV au niveau de la première couche EP d'un premier matériau conducteur. Cette première gravure sélective permet en particulier de choisir l'importance de ce retrait RT1 et donc la distance TR1 séparant la deuxième couche C2 d'un deuxième matériau actif de l'électrode plane EP. Dans un mode de réalisation, le retrait RT1 est compris entre 15 nm et 25 nm, de préférence 20 nm.

Comme illustré à la figure 4F, le procédé selon l'invention comprend une quatrième étape D4 de dépôt ou de croissance d'une troisième couche CI3 d'un troisième matériau isolant. Lors de cette étape, le matériau est déposé en quantité suffisante pour venir combler le retrait RT1 réalisé lors de l'étape GS1 de gravure sélective de la première couche EP d'un matériau conducteur précédente. Dans un mode de réalisation, le troisième matériau isolant est du SiOx. Dans un mode de réalisation, l'étape D4 de dépôt ou de croissance d'une troisième couche CI3 d'un troisième matériau isolant est réalisée par croissance thermique de sorte à combler le retrait réalisé lors de l'étape GS1 de gravure sélective de la première couche EP d'un matériau conducteur.

A l'issue de cette étape, comme illustré à la figure 4G, le procédé comprend une deuxième étape GA2 de gravure anisotrope de la troisième couche CI3 d'un troisième matériau isolant, de sorte que seule la partie de la troisième couche CI3 d'un troisième matériau isolant située dans le retrait RT1 créé lors de l'étape GS1 de gravure sélective de la première couche EP d'un matériau conducteur soit conservée. Lorsque l'étape D4 de dépôt ou de croissance d'une troisième couche CI3 d'un troisième matériau isolant est réalisée par croissance thermique, alors la deuxième étape GA2 de gravure anisotrope de la troisième couche CI3 d'un troisième matériau isolant n'est pas mise en oeuvre, la croissance étant stoppée lorsque le retrait RT1 réalisé lors de l'étape GS1 de gravure sélective de la première couche EP d'un matériau conducteur est comblé.

Comme illustré à la figure 4H, le procédé comprend ensuite une deuxième étape GS2 de gravure sélective de la première couche CI1 d'un premier matériau isolant. Cette gravure va permettre de créer un retrait RT2 dans la surface latérale de l'ouverture OUV au niveau de la première couche CI1 d'un premier matériau isolant. Cette deuxième gravure sélective permet en particulier de choisir l'importance de ce retrait RT2 et donc la distance TR2 séparant la deuxième couche C2 d'un deuxième matériau actif de la première couche CI1 d'un premier matériau isolant. Dans un mode de réalisation, le retrait est compris entre 25 nm et 35 nm, de préférence 30 nm.

Comme illustré à la figure 4I, le procédé comprend également une première étape DC1 de dépôt conforme d'une première couche C1 d'un premier matériau actif. Dans un mode de réalisation, lorsque le premier matériau actif est destiné à former un sélecteur SE, alors ce dernier est choisi parmi le VOx, GeSe, TiOx, TaxOy. Dans un mode de réalisation, lorsque le premier matériau actif est destiné à former un point mémoire PM, alors ce dernier est choisi parmi le HfOx, AlxOy, TaxOy, CuTeGe, GST, TiOx, SiOx. Dans un mode de réalisation, l'épaisseur de la première couche C1 d'un premier matériau actif est comprise entre 5 nm et 10 nm.

Puis comme illustré à la figure 4J, le procédé comprend une cinquième étape D5 de dépôt d'une deuxième couche EF' d'un matériau conducteur. Lors de cette étape, le matériau est déposé en quantité suffisante pour venir combler le retrait RT2 réalisé lors de l'étape GS2 de gravure sélective de la première couche CI1 d'un premier matériau isolant précédente. Dans un mode de réalisation, le matériau conducteur est choisi parmi le TiN, TaN, TaCN, Ta, Ti, W, Cu, Ru, Mo, Co, C, Al et/ou Ag, ou un de leurs alliages.

Ensuite, comme illustré à la figure 4K, le procédé comprend une troisième étape GA3 de gravure anisotrope de la première couche C1 d'un premier matériau actif et de la deuxième couche EF' d'un matériau conducteur, de sorte que seule la partie de la première couche C1 d'un premier matériau actif et de la deuxième couche EF' d'un matériau conducteur située dans le retrait RT2 créé lors de l'étape GS2 de gravure sélective de la première couche CI1 d'un premier matériau isolant est conservée.

Comme illustré à la figure 4L, le procédé comprend également une deuxième étape DC2 de dépôt conforme d'une deuxième couche C2 d'un deuxième matériau actif. Dans un mode de réalisation, lorsque le deuxième matériau actif est destiné à former un sélecteur SE, alors ce dernier est choisi parmi le VOx, GeSe, TiOx, TaxOy. Dans un mode de réalisation, lorsque le deuxième matériau actif est destiné à former un point mémoire PM, alors ce dernier est choisi parmi le HfOx, AlxOy, TaxOy, CuTeGe, GST, TiOx, SiOx. Dans un mode de réalisation, l'épaisseur de la deuxième couche C2 d'un deuxième matériau actif est comprise entre 5 nm et 30 nm. Il est important de noter ici que lorsque le premier matériau actif est apte à former un sélecteur SE (respectivement un point mémoire PM) alors le deuxième matériau actif est apte à former un point mémoire PM (respectivement un sélecteur SE).

Comme illustré à la figure 4M, le procédé comprend enfin une sixième étape D6 de dépôt d'une troisième couche EV d'un matériau conducteur de sorte à venir combler l'ouverture OUV. Dans un mode de réalisation, le matériau conducteur est choisi parmi le TiN, TaN, TaCN, Ta, Ti, W, Cu, Ru, Mo, Co, C, Al et/ou Ag, ou un de leurs alliages. La cellule mémoire CM obtenue à l'issue du procédé est représentée à la figure 5. Comme indiqué sur cette figure, la cellule mémoire CM comporte un point mémoire PM et un sélecteur SE, la position de ces derniers étant fonction des matériaux choisis pour le premier matériau actif et pour le deuxième matériau actif.

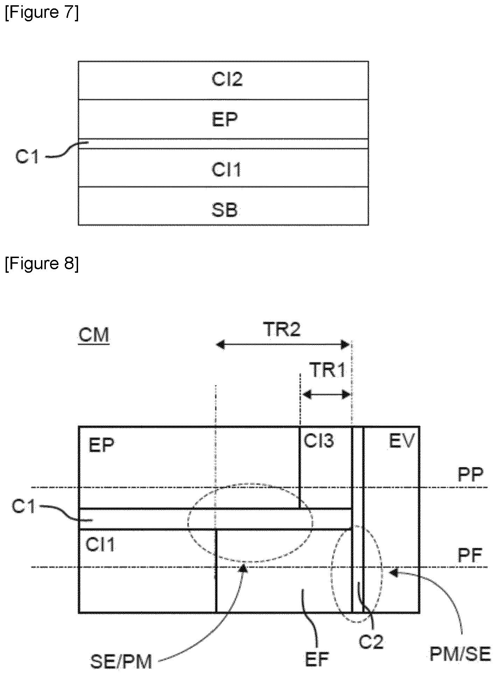

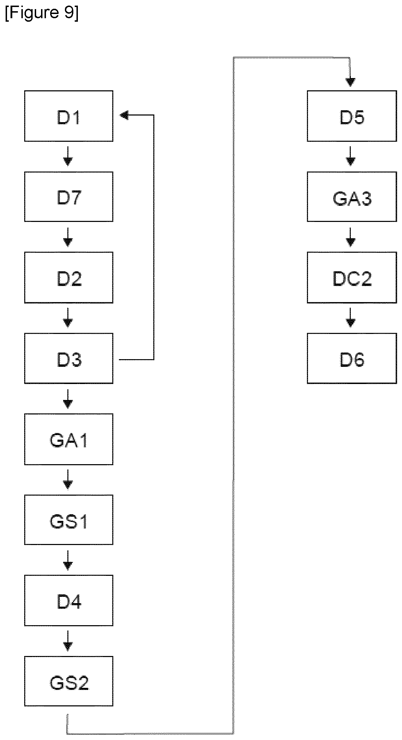

Comme illustré à la figure 7, à la figure 8 et à la figure 9, un troisième aspect de l'invention concerne un procédé de fabrication alternatif d'une mémoire ME selon un premier aspect de l'invention. Le procédé comprend une première étape D1 de dépôt d'une première couche CI1 d'un premier matériau isolant ; une septième étape D7 de dépôt d'une première couche C1 d'un premier matériau actif ; une deuxième étape D2 de dépôt d'une première couche EP d'un matériau conducteur ; une troisième étape D3 de dépôt d'une deuxième couche C12 d'un deuxième matériau isolant, de sorte à obtenir l'empilement de la figure 7. Il diffère donc du procédé selon un deuxième aspect de l'invention par la présence une septième étape D7 de dépôt d'une première couche C1 d'un premier matériau actif. Comme dans le procédé selon le deuxième aspect de l'invention, les quatre étapes décrites ci-dessus peuvent être répétées en fonction du nombre de cellules mémoires CM souhaité. Le procédé selon un troisième aspect de l'invention diffère également du procédé selon un deuxième aspect de l'invention en ce qu'il ne comprend pas une première étape DC1 de dépôt conforme d'une première couche C1 d'un premier matériau actif, ledit matériau actif étant déjà présent de par la mise en oeuvre de septième étape D7 de dépôt d'une première couche C1 d'un premier matériau actif. Les autres étapes restent quant à elles inchangées. Le procédé selon un troisième aspect de l'invention permet d'obtenir une cellule mémoire CM telle que représentée à la figure 8. Comme indiqué sur cette figure, la cellule mémoire comporte un point mémoire PM et un sélecteur SE, la position de ces derniers étant fonction des matériaux choisis pour le premier matériau actif et pour le deuxième matériau actif.

Dans un mode de réalisation, le retrait RT2 créé lors de l'étape GS2 de gravure sélective de la première couche CI1 d'un premier matériau isolant est largement supérieur au retrait RT1 créé lors de l'étape GS1 de gravure sélective de la première couche EP d'un matériau conducteur de sorte à avoir une grande surface de l'électrode plane EP en regard de l'électrode flottante EF (par exemple, la différence entre le retrait RT2 créé lors de l'étape GS2 de gravure sélective de la première couche CI1 et le retrait RT1 créé lors de l'étape GS1 de gravure sélective de la première couche EP est supérieur à 10 nm et inférieur ou égal à 100 nm, c'est-à-dire 10 nm < TR2-TR1 ≤ 100 nm). Dans ce mode de réalisation, le premier matériau actif est choisi de sorte à obtenir un sélecteur SE et le deuxième matériau actif est choisi de sorte à obtenir un point mémoire PM. Le sélecteur SE ainsi obtenu peut tirer avantage de la grande surface en regard précédemment décrite.

Dans un mode de réalisation alternatif, le retrait RT2 créé lors de l'étape GS2 de gravure sélective de la première couche CI1 d'un premier matériau isolant est légèrement supérieur au retrait RT1 créé lors de l'étape GS1 de gravure sélective de la première couche EP d'un matériau conducteur (par exemple, la différence entre le retrait RT2 créé lors de l'étape GS2 de gravure sélective de la première couche CI1 et le retrait RT1 créé lors de l'étape GS1 de gravure sélective de la première couche EP est inférieure ou égale à 10 nm, c'est-à-dire TR2-TR1 ≤ 10 nm) de sorte à avoir une faible surface de l'électrode plane EP en regard de l'électrode flottante EF. Dans ce mode de réalisation, le premier matériau actif est choisi de sorte à obtenir un point mémoire PM et le deuxième matériau actif est choisi de sorte à obtenir un sélecteur SE. Le point mémoire PM ainsi obtenu occupe une surface très faible ce qui permet d'augmenter la densité de stockage d'une mémoire ME utilisant un tel point mémoire PM.

Dans un mode de réalisation, la mémoire ME obtenue est telle que l'électrode plane EP est séparée de la deuxième couche C2 d'un deuxième matériau actif par une première distance de séparation TR1 et la première couche CI1 d'un premier matériau isolant est séparée de la deuxième couche C2 d'un deuxième matériau actif. De plus, la deuxième distance TR2 est choisie en fonction de la nature du deuxième matériau actif. On notera que la deuxième distance TR2 est telle que TR2 > TR1+T_{C1} avec T_{C1} l'épaisseur de la première couche C1 d'un premier matériau actif. Cette relation traduit simplement le fait que l'électrode flottante EF a bien une partie en regard de l'électrode plane EP.

## Revendications

1. Mémoire (ME) comprenant au moins une cellule mémoire (CM), chaque cellule mémoire (CM) comprenant :
- une première électrode, dite électrode plane (EP), s'étendant essentiellement selon un premier plan (PP) ;
- une deuxième électrode, dite électrode flottante (EF), s'étendant essentiellement selon un deuxième plan (PF), parallèle au premier plan (PP) ;
- une troisième électrode, dite électrode verticale (EV), s'étendant essentiellement selon une direction perpendiculairement au premier plan (PP) ;
l'électrode plane (EP) comportant au moins une première partie en regard d'une première partie de l'électrode flottante (EF), la première partie de l'électrode plane (EP) et la première partie de l'électrode flottante (EF) étant séparées par une première couche (C1) d'un premier matériau actif (C1),
l'électrode verticale (EV) comportant au moins une première partie en regard d'une deuxième partie de l'électrode flottante (EF), la première partie de l'électrode verticale (EV) et la deuxième partie de l'électrode flottante (EF) étant séparée par une deuxième couche (C2) d'un deuxième matériau actif, le premier matériau actif étant apte à former un sélecteur (SE) ou un point mémoire (PM) et le deuxième matériau actif étant apte à former un point mémoire (PM) ou un sélecteur (SE), la première électrode (EP) et la deuxième électrode (EF) ne partageant aucun plan qui soit parallèle au premier plan (PP) ou au deuxième plan (PF).

2. Mémoire selon la revendication 1 dans laquelle la première couche (CI1) d'un premier matériau isolant est séparée de la deuxième couche (C2) d'un deuxième matériau actif par une deuxième distance de séparation TR2, la deuxième distance TR2 étant choisie en fonction de la nature du permet matériau actif.

3. Procédé de fabrication d'une mémoire (ME) comprenant au moins une cellule mémoire (CM), ledit procédé comprenant :
- une première étape (D1) de dépôt d'une première couche (CI1) d'un premier matériau isolant ;
- une deuxième étape (D2) de dépôt d'une première couche (EP) d'un matériau conducteur ;
- une troisième étape (D3) de dépôt d'une deuxième couche (C12) d'un deuxième matériau isolant ;
lesdites première étape (D1) de dépôt d'une première couche (CI1) d'un premier matériau isolant, deuxième étape (D2) de dépôt d'une première couche (EP) d'un matériau conducteur et une troisième étape (D3) de dépôt d'une deuxième couche (C12) d'un deuxième matériau isolant pouvant être itérées une pluralité de fois ; le procédé comprenant également :
- une première étape (GA1) de gravure anisotropique, de sorte à créer une ouverture (OUV) dans la première couche (CI1) d'un premier matériau isolant, la première couche (EP) d'un matériau conducteur et la deuxième couche (CI2) d'un deuxième matériau isolant ;
- une première étape (GS1) de gravure sélective de la première couche (EP) d'un matériau conducteur de sorte à former un retrait (RT1) dans ladite première couche (EP) d'un matériau conducteur ;
- une étape (D4) de dépôt ou de croissance d'une troisième couche (CI3) d'un troisième matériau isolant de sorte à combler le retrait (RT1) obtenu lors de la première étape (GS1) de gravure sélective de la première couche (EP) d'un matériau conducteur ;
- une deuxième étape (GS2) de gravure sélective de la première couche (CI1) d'un premier matériau isolant ;
- une première étape (DC1) de dépôt conforme d'une première couche (C1) d'un premier matériau actif ;
- une cinquième étape (D5) de dépôt d'une deuxième couche (EF') d'un matériau conducteur ;
- une troisième étape (GA3) de gravure anisotrope de la première couche (C1) d'un premier matériau actif et de la deuxième couche (EF') d'un matériau conducteur ;
- une deuxième étape (DC2) de dépôt conforme d'une deuxième couche (C2) d'un deuxième matériau actif ;
- une sixième étape (D6) de dépôt d'une troisième couche (EV) d'un matériau conducteur ;
le premier matériau actif étant apte à former un sélecteur (SE) ou un point mémoire (PM) et le deuxième matériau actif étant apte à former un point mémoire (PM) ou un sélecteur (SE).

4. Procédé de fabrication d'une mémoire (ME) comprenant au moins une cellule mémoire (CM), ledit procédé comprenant :
- une première étape (D1) de dépôt d'une première couche (CI1) d'un premier matériau isolant ;
- une septième étape (D7) de dépôt d'une première couche (C1) d'un premier matériau actif ;
- une deuxième étape (D2) de dépôt d'une première couche (EP) d'un matériau conducteur ;
- une troisième étape (D3) de dépôt d'une deuxième couche (CI2) d'un deuxième matériau isolant ;
lesdites première étape (D1) de dépôt d'une première couche (CI1) d'un premier matériau isolant, septième étape (D7) de dépôt d'une première couche (C1) d'un premier matériau actif, deuxième étape (D2) de dépôt d'une première couche (EP) d'un matériau conducteur et troisième étape (D3) de dépôt d'une deuxième couche (CI2) d'un deuxième matériau isolant pouvant être itérées une pluralité de fois ; le procédé comprenant également :
- une première étape (GA1) de gravure anisotropique, de sorte à créer une ouverture (OUV) dans la première couche (CI1) d'un premier matériau isolant, la première couche (C1) d'un premier matériau actif, la première couche (EP) d'un matériau conducteur et la deuxième couche (CI2) d'un deuxième matériau isolant ;
- une première étape (GS1) de gravure sélective de la première couche (EP) d'un matériau conducteur de sorte à former un retrait (RT1) dans ladite première couche (EP) d'un matériau conducteur ;
- une étape (D4) de dépôt ou de croissance d'une troisième couche (CI3) d'un troisième matériau isolant de sorte à combler le retrait (RT1) obtenu lors de la première étape (GS1) de gravure sélective de la première couche (EP) d'un matériau conducteur ;
- une deuxième étape (GS2) de gravure sélective de la première couche (CI1) d'un premier matériau isolant ;
- une cinquième étape (D5) de dépôt d'une deuxième couche (EF') d'un matériau conducteur ;
- une troisième étape (GA3) de gravure anisotrope de la deuxième couche (EF') d'un matériau conducteur ;
- une deuxième étape (DC2) de dépôt conforme d'une deuxième couche (C2) d'un deuxième matériau actif ;
- une sixième étape (D6) de dépôt d'une troisième couche (EV) d'un matériau conducteur ;
le premier matériau actif étant apte à former un sélecteur (SE) ou un point mémoire (PM) et le deuxième matériau actif étant apte à former un point mémoire (PM) ou un sélecteur (SE).

5. Procédé selon l'une des deux revendications précédentes dans lequel, lorsque l'étape (D4) de dépôt ou de croissance d'une troisième couche (CI3) d'un troisième matériau isolant est une étape de dépôt, alors cette dernière comprend :
- une première sous-étape étape (D41) de dépôt d'une troisième couche d'un troisième (CI3) matériau isolant ;
- une deuxième sous-étape (GA2) de gravure anisotrope de la troisième couche (CI3) d'un troisième matériau isolant.

6. Procédé selon l'une des revendications 3 à 4 dans lequel l'étape (D4) de dépôt ou de croissance d'une troisième couche (CI3) d'un troisième matériau isolant est une étape croissance thermique.

7. Procédé selon l'une des quatre revendications précédentes dans lequel le matériau conducteur est choisi parmi le TiN, TaN, TaCN, Ta, Ti, W, Cu, Ru, Mo, Co, C, Al et/ou Ag, ou un alliage comprenant au moins deux desdits métaux.

8. Procédé selon l'une des cinq revendications précédentes dans lequel, lorsque le matériau actif est destiné à former un sélecteur (SE), alors ce dernier est choisi parmi le VOx, GeSe, TiOx, TaxOy.

9. Procédé selon l'une des six revendications précédentes dans lequel, lorsque le matériau actif est destiné à former un point mémoire (PM), alors ce dernier est choisi parmi le HfOx, AlxOy, TaxOy, CuTeGe, GST, TiOx, SiOx.

## Patentansprüche

1. Speicher (ME) mit mindestens einer Speicherzelle (CM), wobei jede Speicherzelle (CM) umfasst:
- eine erste, sogenannte ebene Elektrode (EP), die sich im Wesentlichen in einer ersten Ebene (PP) erstreckt;
- eine zweite, sogenannte schwimmende Elektrode (EF), die sich im Wesentlichen in einer zweiten Ebene (PF), parallel zur ersten Ebene (PP) erstreckt;
- eine dritte, sogenannte vertikale Elektrode (EV), die sich im Wesentlichen in einer zur ersten Ebene (PP) senkrechten Richtung erstreckt;
wobei die ebene Elektrode (EP) mindestens einen ersten Teil gegenüber einem ersten Teil der schwimmenden Elektrode (EF) aufweist und wobei der erste Teil der ebenen Elektrode (EP) und der erste Teil der schwimmenden Elektrode (EF) durch eine erste Schicht (C1) eines ersten aktiven Materials (C1) voneinander getrennt sind,
wobei die vertikale Elektrode (EV) mindestens einen ersten Teil gegenüber einem zweiten Teil der schwimmenden Elektrode (EF) umfasst und wobei der erste Teil der vertikalen Elektrode (EV) und der zweite Teil der schwimmenden Elektrode (EF) durch eine zweite Schicht (C2) eines zweiten aktiven Materials voneinander getrennt sind, wobei das erste aktive Material dazu geeignet ist, einen Selektor (SE) oder einen Speicherpunkt (PM) zu bilden und das zweite aktive Material dazu geeignet ist, einen Speicherpunkt (PM) oder einen Selektor (SE) zu bilden, wobei die erste Elektrode (EP) und die zweite Elektrode (EF) keine Ebene teilen, die zur ersten Ebene (PP) oder zur zweiten Ebene (PF) parallel ist.

2. Speicher nach Anspruch 1, bei dem die erste Schicht (CI1) eines ersten isolierenden Materials von der zweiten Schicht (C2) eines zweiten aktiven Materials durch einen zweiten Trennungsabstand TR2 getrennt ist, wobei der zweite Abstand TR2 abhängig von der Art des aktiven Materials gewählt wird.

3. Fertigungsverfahren für einen Speicher (ME) mit mindestens einer Speicherzelle (CM), wobei dieses Verfahren umfasst:
- einen ersten Schritt (D1) des Auftragens einer ersten Schicht (CI1) eines ersten isolierenden Materials;
- einen zweiten Schritt (D2) des Auftragens einer ersten Schicht (EP) eines leitenden Materials;
- einen dritten Schritt (D3) des Auftragens einer zweiten Schicht (CI2) eines zweiten isolierenden Materials;
wobei dieser erste Schritt (D1) des Auftragens einer ersten Schicht (CI1) eines ersten isolierenden Materials, dieser zweite Schritt (D2) des Auftragens einer ersten Schicht (EP) eines leitenden Materials und dieser dritte Schritt (D3) des Auftragens einer zweiten Schicht (CI2) eines zweiten isolierenden Materials mehrmalig wiederholt werden können; wobei das Verfahren zudem Folgendes umfasst:
- einen ersten Schritt (GA1) des anisotropen Gravierens, sodass in der ersten Schicht (CI1) eines ersten isolierenden Materials, in der ersten Schicht (EP) eines leitenden Materials und in der zweiten Schicht (CI2) eines zweiten isolierenden Materials eine Öffnung (OUV) geschaffen wird,
- einen ersten Schritt (GS1) des selektiven Gravierens der ersten Schicht (EP) eines leitenden Materials, sodass in der ersten Schicht (EP) eines leitenden Materials eine Schrumpfung (RT1) gebildet wird;
- einen Schritt (D4) des Auftragens oder Wachstums einer dritten Schicht (CI3) eines dritten isolierenden Materials, sodass die beim ersten Schritt (GS1) des selektiven Gravierens der ersten Schicht (EP) eines leitenden Materials erzielte Schrumpfung (RT1) gefüllt wird;
- einen zweiten Schritt (GS2) des selektiven Gravierens der ersten Schicht (CI1) eines ersten isolierenden Materials;
- einen ersten Schritt (DC1) des angemessenen Auftragens einer ersten Schicht (C1) eines ersten aktiven Materials;
- einen fünften Schritt (D5) des Auftragens einer zweiten Schicht (EF') eines leitenden Materials;
- einen dritten Schritt (GA3) des anisotropen Gravierens der ersten Schicht (C1) eines ersten aktiven Materials und der zweiten Schicht (EF') eines leitenden Materials;
- einen zweiten Schritt (DC2) des angemessenen Auftragens einer zweiten Schicht (C2) eines zweiten aktiven Materials;
- einen sechsten Schritt (D6) des Auftragens einer dritten Schicht (EV) eines leitenden Materials;
wobei das erste aktive Material dazu geeignet ist, einen Selektor (SE) oder einen Speicherpunkt (PM) zu bilden und das zweite aktive Material dazu geeignet ist, einen Speicherpunkt (PM) oder einen Selektor (SE) zu bilden.

4. Fertigungsverfahren für einen Speicher (ME) mit mindestens einer Speicherzelle (CM), wobei dieses Verfahren umfasst:
- einen ersten Schritt (D1) des Auftragens einer ersten Schicht (CI1) eines ersten isolierenden Materials;
- einen siebten Schritt (D7) des Auftragens einer ersten Schicht (C1) eines ersten aktiven Materials;
- einen zweiten Schritt (D2) des Auftragens einer ersten Schicht (EP) eines leitenden Materials;
- einen dritten Schritt (D3) des Auftragens einer zweiten Schicht (CI2) eines zweiten isolierenden Materials;
wobei dieser erste Schritt (D1) des Auftragens einer ersten Schicht (CI1) eines ersten isolierenden Materials, dieser siebte Schritt (D7) des Auftragens einer ersten Schicht (C1) eines ersten aktiven Materials, dieser zweite Schritt (D2) des Auftragens einer ersten Schicht (EP) eines leitenden Materials und dieser dritte Schritt (D3) des Auftragens einer zweiten Schicht (CI2) eines zweiten isolierenden Materials mehrmalig wiederholt werden können; wobei das Verfahren zudem Folgendes umfasst:
- einen ersten Schritt (GA1) des anisotropen Gravierens, sodass in der ersten Schicht (CI1) eines ersten isolierenden Materials, in der ersten Schicht (C1) eines ersten aktiven Materials, in der ersten Schicht (EP) eines leitenden Materials und in der zweiten Schicht (CI2) eines zweiten isolierenden Materials eine Öffnung (OUV) geschaffen wird,
- einen ersten Schritt (GS1) des selektiven Gravierens der ersten Schicht (EP) eines leitenden Materials, sodass in der ersten Schicht (EP) eines leitenden Materials eine Schrumpfung (RT1) gebildet wird;
- einen Schritt (D4) des Auftragens oder Wachstums einer dritten Schicht (CI3) eines dritten isolierenden Materials, sodass die beim ersten Schritt (GS1) des selektiven Gravierens der ersten Schicht (EP) eines leitenden Materials erzielte Schrumpfung (RT1) gefüllt wird;
- einen zweiten Schritt (GS2) des selektiven Gravierens der ersten Schicht (CI1) eines ersten isolierenden Materials;
- einen fünften Schritt (D5) des Auftragens einer zweiten Schicht (EF') eines leitenden Materials;
- einen dritten Schritt (GA3) des anisotropen Gravierens der zweiten Schicht (EF') eines leitenden Materials;
- einen zweiten Schritt (DC2) des angemessenen Auftragens einer zweiten Schicht (C2) eines zweiten aktiven Materials;
- einen sechsten Schritt (D6) des Auftragens einer dritten Schicht (EV) eines leitenden Materials;
wobei das erste aktive Material dazu geeignet ist, einen Selektor (SE) oder einen Speicherpunkt (PM) zu bilden und das zweite aktive Material dazu geeignet ist, einen Speicherpunkt (PM) oder einen Selektor (SE) zu bilden.

5. Verfahren nach einem der zwei vorausgehenden Ansprüche, bei dem
wenn es sich bei dem Schritt (D4) des Auftragens oder Wachstums einer dritten Schicht (CI3) eines dritten isolierenden Materials um ein Auftragen handelt, dieser Schritt dann Folgendes umfasst:
- einen ersten Unterschritt (D41) des Auftragens einer dritten Schicht eines dritten isolierenden Materials (CI3);
- einen zweiten Unterschritt (GA2) des anisotropen Gravierens der dritten Schicht (CI3) eines dritten isolierenden Materials.

6. Verfahren nach einem der Ansprüche 3 bis 4, bei dem der Schritt (D4) des Auftragens oder Wachstums einer dritten Schicht (CI3) eines dritten isolierenden Materials ein thermischer Wachstumsschritt ist.

7. Verfahren nach einem der vier vorausgehenden Ansprüche, bei dem das leitende Material aus der Gruppe von TiN, TaN, TaCN, Ta, Ti, W, Cu, Ru, Mo, Co, C, Al und/oder Ag oder aus einer Legierung mit mindestens zwei dieser Metalle ausgewählt wird.

8. Verfahren nach einem der fünf vorausgehenden Ansprüche, bei dem, wenn das aktive Material dazu bestimmt ist, einen Selektor (SE) zu bilden, dieser aus der Gruppe von Vox, GeSe, TiOx, TaxOy ausgewählt wird.

9. Verfahren nach einem der sechs vorausgehenden Ansprüche, bei dem, wenn das aktive Material dazu bestimmt ist, einen Speicherpunkt (PM) zu bilden, dieser aus der Gruppe von HfOx, AlxOy, TaxOy, CuTeGe, GST, TiOx, SiOx ausgewählt wird.

## Claims

1. Memory (ME) comprising at least one memory cell (CM), each memory cell (CM) comprising:
- a first electrode, referred to as planar electrode (EP), extending essentially along a first plane (PP);
- a second electrode, referred to as floating electrode (EF), extending essentially along a second plane (PF), parallel to the first plane (PP);
- a third electrode, referred to as vertical electrode (EV), extending essentially along a direction perpendicular to the first plane (PP);
the planar electrode (EP) comprising at least one first part facing a first part of the floating electrode (EF), the first part of the planar electrode (EP) and the first part of the floating electrode (EF) being separated by a first layer (C1) of a first active material (C1), the vertical electrode (EV) comprising at least one first part facing a second part of the floating electrode (EF), the first part of the vertical electrode (EV) and the second part of the floating electrode (EF) being separated by a second layer (C2) of a second active material, the first active material being capable of forming a selector (SE) or a memory point (PM) and the second active material being capable of forming a memory point (PM) or a selector (SE), the first electrode (EP) and the second electrode (EF) not sharing any plane that is parallel to the first plane (PP) or to the second plane (PF).

2. Memory according to claim 1 wherein the first layer (CI1) of a first insulator material is separated from the second layer (C2) of a second active material by a second separation distance TR2, the second distance TR2 being chosen as a function of the nature of the active material.

3. Method for manufacturing a memory (ME) comprising at least one memory cell (CM), said method comprising:
- a first step (D1) of deposition of a first layer (CI1) of a first insulator material;
- a second step (D2) of deposition of a first layer (EP) of a conductor material;
- a third step (D3) of deposition of a second layer (CI2) of a second insulator material;
said first step (D1) of deposition of a first layer (CI1) of a first insulator material, second step (D2) of deposition of a first layer (EP) of a conductor material and third step (D3) of deposition of a second layer (CI2) of a second insulator material being able to be iterated a plurality of times; the method also comprising:
- a first step (GA1) of anisotropic etching, so as to create an opening (OUV) in the first layer (CI1) of a first insulator material, the first layer (EP) of a conductor material and the second layer (CI2) of a second insulator material;
- a first step (GS1) of selective etching of the first layer (EP) of a conductor material so as to form an indent (RT1) in said first layer (EP) of a conductor material;
- a step (D4) of deposition or growth of a third layer (CI3) of a third insulator material so as to fill the indent (RT1) obtained during the first step (GS1) of selective etching of the first layer (EP) of a conductor material;
- a second step (GS2) of selective etching of the first layer (CI1) of a first insulator material;
- a first step (DC1) of conformal deposition of a first layer (C1) of a first active material;
- a fifth step (D5) of deposition of a second layer (EF') of a conductor material;
- a third step (GA3) of anisotropic etching of the first layer (C1) of a first active material and the second layer (EF') of a conductor material;
- a second step (DC2) of conformal deposition of a second layer (C2) of a second active material;
- a sixth step (D6) of deposition of a third layer (EV) of a conductor material;
the first active material being capable of forming a selector (SE) or a memory point (PM) and the second active material being capable of forming a memory point (PM) or a selector (SE).

4. Method for manufacturing a memory (ME) comprising at least one memory cell (CM), said method comprising:
- a first step (D1) of deposition of a first layer (CI1) of a first insulator material;
- a seventh step (D7) of deposition of a first layer (C1) of a first active material;
- a second step (D2) of deposition of a first layer (EP) of a conductor material;
- a third step (D3) of deposition of a second layer (CI2) of a second insulator material;
said first step (D1) of deposition of a first layer (CI1) of a first insulator material, seventh step (D7) of deposition of a first layer (C1) of a first active material, second step (D2) of deposition of a first layer (EP) of a conductor material and third step (D3) of deposition of a second layer (CI2) of a second insulator material being able to be iterated a plurality of times; the method also comprising:
- a first step (GA1) of anisotropic etching, so as to create an opening (OUV) in the first layer (CI1) of a first insulator material, the first layer (C1) of a first active material, the first layer (EP) of a conductor material and the second layer (CI2) of a second insulator material;
- a first step (GS1) of selective etching of the first layer (EP) of a conductor material so as to form an indent (RT1) in said first layer (EP) of a conductor material;
- a step (D4) of deposition or growth of a third layer (CI3) of a third insulator material so as to fill the indent (RT1) obtained during the first step (GS1) of selective etching of the first layer (EP) of a conductor material;
- a second step (GS2) of selective etching of the first layer (CI1) of a first insulator material;
- a fifth step (D5) of deposition of a second layer (EF') of a conductor material;
- a third step (GA3) of anisotropic etching of the second layer (EF') of a conductor material;
- a second step (DC2) of conformal deposition of a second layer (C2) of a second active material;
- a sixth step (D6) of deposition of a third layer (EV) of a conductor material;
the first active material being capable of forming a selector (SE) or a memory point (PM) and the second active material being capable of forming a memory point (PM) or a selector (SE).

5. Method according to one of the two preceding claims wherein, when step (D4) of deposition or growth of a third layer (CI3) of a third insulator material is a deposition step, then the latter comprises:
- a first sub-step (D41) of deposition of a third layer of a third (CI3) insulator material;
- a second sub-step (GA2) of anisotropic etching of the third layer (CI3) of a third insulator material.

6. Method according to one of claims 3 to 4 wherein step (D4) of deposition or growth of a third layer (CI3) of a third insulator material is a thermal growth step.

7. Method according to one of the four preceding claims wherein the conductor material is selected from TiN, TaN, TaCN, Ta, Ti, W, Cu, Ru, Mo, Co, C, Al and/or Ag, or an alloy comprising at least two of said metals.

8. Method according to one of the five preceding claims wherein, when the active material is intended to form a selector (SE), then the latter is selected from VOx, GeSe, TiOx, TaxOy.

9. Method according to one of the six preceding claims wherein, when the active material is intended to form a memory point (PM), then the latter is selected from HfOx, AlxOy, TaxOy, CuTeGe, GST, TiOx, SiOx.
